# EUROPÄISCHE PATENTSCHRIFT

(11) **EP 1 145 610 B1**
(45) Veröffentlichungstag und Bekanntmachung des Hinweises auf die Patenterteilung: **13.08.2008**
(21) Anmeldenummer: 00987052.8
(22) Anmeldetag: 01.11.2000
(51) Int. Cl.: H05K 5/00, H05K 7/20, B60R 16/02, H05K 7/14

(54) **ELEKTRONISCHES STEUERGERÄT**
ELECTRONIC CONTROL DEVICE
APPAREIL DE COMMANDE ELECTRONIQUE

(30) Priorität: 05.11.1999 DE 19953191
(43) Veröffentlichungstag der Anmeldung: 17.10.2001
(73) Patentinhaber: ROBERT BOSCH GMBH, 70442 Stuttgart (DE)
(72) Erfinder: RIEHL, Guenther, 77830 Buehlertal (DE); SEVERIN, Bernhard, 77830 Buehlertal (DE)
(86) Internationale Anmeldenummer: PCT/DE2000/003833
(87) Internationale Veröffentlichungsnummer: WO 2001/033926

(56) Entgegenhaltungen:
- EP-A- 0 359 606
- DE-A- 19 832 560
- DE-A- 19 851 455
- DE-U- 8 909 674

## Beschreibung

### Stand der Technik

Die Erfindung betrifft ein elektronisches Steuergerät mit den im Oberbegriff des unabhängigen Anspruchs 1 angegebenen Merkmalen.

Ein derartiges Steuergerät ist aus der DE 198 51 455 A1 bekannt und wird beispielsweise zur Steuerung einer elektromotorisch betriebenen Antriebseinheit eingesetzt. Das bekannte Steuergerät umfaßt ein kastenförmiges, mit zwei Steckerteilen versehenes Bodenteil aus Kunststoff, in welches die Leiterplatte eingesetzt wird und das mit einem Deckel verschließbar ist. Das kastenförmige Bodenteil wird zusammen mit den Stekkerteilen als Spritzgußteil hergestellt.

Nachteilig bei dem bekannten Steuergerät ist, daß die Einbringung von Leistungsbauelementen in das Gehäuse problematisch ist, da keine Wärmesenke vorhanden ist und die Wärme aus dem geschlossenen Kunststoffgehäuse nicht an die Umgebung abgegeben werden kann. Zudem ist die Einbringung einer Wärmesenke in das Gehäuse recht umständlich und hätte eine nachteilige Vergrößerung des Gehäuses zur Folge. Eine optimale Wärmeableitung bei gleichzeitig einfachem mechanischen Aufbau ist mit dem bekannten Steuergerät nicht möglich.

Aus EP-A-0 359 606 ist ferner ein Gehäuse für eine Leiterplatte bekannt, das ein Gehäuserahmen aufweist, der mit einer als Wärmesenke ausgebildeten Bodenplatte und mit einem Deckelteil versehen ist.

### Vorteile der Erfindung

Mit dem erfindungsgemäßen Steuergerät nach dem Anspruch 1 der Anmeldung werden die im Stand der Technik bekannten Nachteile vermieden. Das Steuergerät ist preiswert aus wenigen Bauteilen zu fertigen und äußerst kompakt aufgebaut. Besonders vorteilhaft ist die sehr flache, platzsparende Bauweise mit geringer Bauhöhe in Kombination mit der Realisierung einer effizienten Wärmeableitung der von den Leistungsbauelementen erzeugten Wärme. Dies wird vorteilhaft erreicht, indem das Gehäuse durch einen beidseitig offenen Gehäuserahmen gebildet wird, dessen offene Unterseite mit einer das Bodenteil des Gehäuses bildenden metallischen Wärmesenke abgedeckt wird, wobei die in dem Gehäuse angeordneten Leistungsbauelemente auf ihrer von der Leiterplatte abgewandten als Kühlfläche vorgesehenen Seite mit der Wärmesenke kontaktiert sind. Kontaktelemente der Steckerteile und hochstomführende Leiterstreifen werden in einfacher Weise durch ein Stanzgitter gebildet, welches durch Spritzgießen in den Gehäuserahmen eingebettet werden kann. Die Anschlüsse der Leistungsbauelemente können vorteilhaft mit Leiterbahnen der Leiterplatte und/oder mit nicht in Kunststoff eingebetteten Abschnitten des Stanzgitters kontaktiert werden.

Weiterentwicklungen der Erfindung und vorteilhafte Ausführungen werden durch die in den Unteransprüchen angegebenen Merkmale ermöglicht.

Vorteilhaft ist der Gehäuserahmen mit Querstegen versehen ist, an welchen Haltemittel für die Leistungsbauelemente und/oder Haltemittel für weitere elektrische Bauelemente ausgebildet sind. Hierdurch wird erreicht, daß nicht alle Bauelemente auf die Leiterplatte aufgebracht werden müssen und große Bauelemente, welche viel Platz beanspruchen, unabhängig von der Leiterplatte an den Haltemitteln des Gehäuserahmens festgelegt werden können. Durch diese Maßnahme wird die Bauhöhe der Anordnung stark reduziert. Außerdem wird durch die Querstege ein sehr stabiler Aufbau in Verbindung mit einer erleichterten Montage realisiert. So können beispielsweise große Kondensatoren an dem Gehäuserahmen vormontiert werden und anschließend die Leiterplatte an dem Gehäuserahmen festgelegt werden.

Vorteilhaft werden die Kontaktelemente des wenigstens einen Steckerteils durch die metallischen Leiterstreifen des Stanzgitters gebildet.

Weiterhin ist vorteilhaft die Leiterplatte zwischen den Leiterstreifen und dem Deckelteil anzuordnen. Hierdurch wird erreicht, daß die Anschlüsse von Leistungsbauelementen, welche auf der dem metallischen Bodenteil zugewandten Seite der Leiterplatte angeordnet sind mit der Leiterplatte und/oder mit den Leiterstreifen des Stanzgitters elektrisch verbunden werden können. So ist es beispielsweise möglich, hochtromführende Anschlüsse von Leistungstransistoren unmittelbar mit den Leiterstreifen zu kontaktieren und signalstromführende Anschlüsse direkt mit der Leiterplatte zu verbinden.

Dadurch, daß zur Oberseite des Gehäuserahmens hin abgebogene Kontaktabschnitte der Leiterstreifen durch Kontaktöffnungen der Leiterplatte hindurchgeführt und mit der Leiterplatte elektrisch verbunden werden, läßt sich die elektrische Verbindung zwischen Stanzgitter und Leiterplatte in einfacher Weise beispielsweise durch Tauchlötung herstellen.

Vorteilhaft ist die Oberseite und/oder Unterseite des Gehäuserahmens mit einer umlaufenden Dichtung versehen, auf welche das Deckelteil und das Bodenteil aufgelegt werden. Ein besonders guter Schutz gegen Feuchtigkeit und Umwelteinflüsse kann dadurch realisiert werden, daß das aus Gehäuserahmen, metallischem Bodenteil und Deckelteil gebildete Gehäuse ein hermetisch dicht verschlossenes Gehäuse ist.

Die kompakte, flache Bauweise kann noch dadurch verbessert werden, daß das metallische Bodenteil mit wenigstens einer Versenkung und/oder wenigstens einem Podest zur Anlage der Leistungsbauelemente und/oder der weiteren elektrischen Bauelemente versehen ist.

### Zeichnungen

Ein Ausführungsbeispiel der Erfindung wird in den Zeichnungen dargestellt und in der nachfolgenden Beschreibung erläutert. Es zeigt
Fig. 1 eine perspektivische Ansicht des Gehäuserahmens mit dem darin teilweise eingebetteten, durch ein Stanzgitter gebildeten Leiterstreifen,
Fig. 2 das Stanzgitter mit den Leiterstreifen,
Fig. 3 das metallische Bodenteil,
Fig. 4 eine perspektivische Ansicht des zusammengebauten Steuergerätes bei abgenommenem Deckel,
Fig. 5 eine seitliche Ansicht des Steuergerätes aus Fig. 4 mit Deckel.

### Beschreibung eines Ausführungsbeispiels

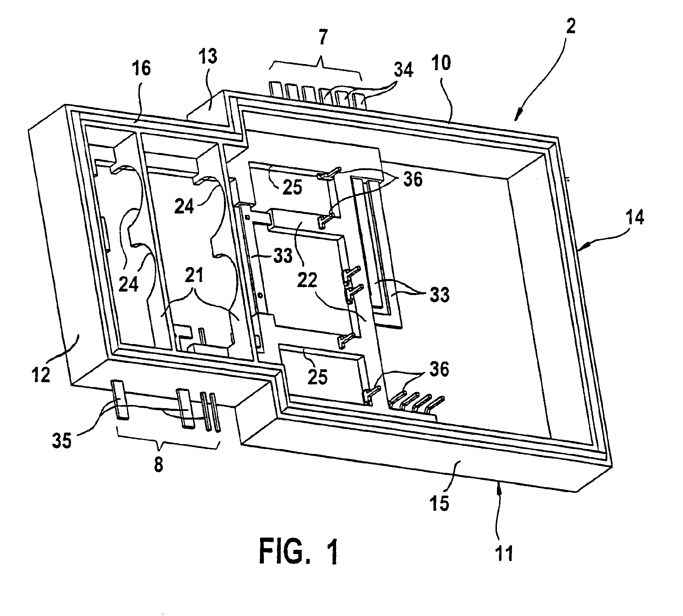

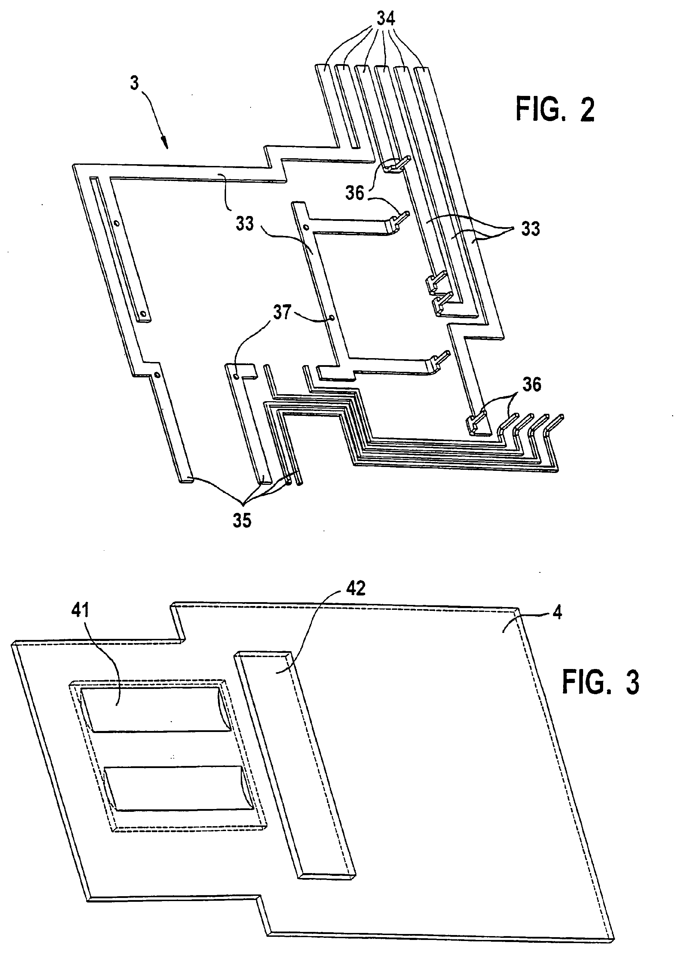

Das Gehäuse 1 des erfindungsgemäßen Steuergerätes umfaßt einen aus vier Seitenwänden 12,13,14 und 15 gebildeten Gehäuserahmen 2 mit einer offenen Unterseite 11 und einer offenen Oberseite 10, wie er in Fig. 1 dargestellt ist. Der Rahmen weist auf seiner Oberseite 10 und Unterseite 11 eine umlaufende Dichtung 16 auf. Der Gehäuserahmen 2 ist als Spritzgußteil aus Kunststoff mit darin teilweise eingebetteten metallischen Leiterstreifen 33 hergestellt. Die Leiterstreifen 33 sind aus einem Stanzgitter 3 gebildet, wie am besten in Fig. 2 zu erkennen ist. Durch die Leiterstreifen des Stanzgitters 3 werden Kontaktelemente 34 für ein erstes Steckerteil 7 und Kontaktelemente 35 für ein zweites Steckerteil 8 sowie hochstromführende Leiterzüge ausgebildet. Einige der Leiterstreifen 33 sind mit Öffnungen 37 für Anschlußstifte von elektrischen Bauelementen versehen. Die Enden der Leiterstreifen 33 sind teilweise rechtwinklig abgebogen, wobei die abgebogenen Enden Kontaktabschnitte 36 zum Anschluß der Leiterstreifen 33 an eine Leiterplatte 6 ausbilden, wie weiter unten noch erläutert wird. Das Stanzgitter 3 wird in herkömmlicher Weise durch Stanzen und anschließendes Trennen von Verbindungsstegen, welche die Leiterstreifen 33 miteinander verbinden, hergestellt. Die Verbindungsstege können vor dem Einspritzen der Leiterstreifen in den Gehäuserahmen 3 vereinzelt werden oder nach dem Einspritzen durch entsprechend ausgebildete Aussparungen des Gehäuserahmens 2 getrennt werden. Wie in Fig. 1 zu erkennen ist, bilden die Abschnitte 34 der Leiterstreifen ein erstes Steckerteil 7 und die Abschnitte 35 ein zweites Stekkerteil 8 aus. Wie in Fig. 1 weiterhin zu erkennen ist, weist der Gehäuserahmen 2 Querstege 21,22 auf, welche an den Innenseiten der Seitenwände 12-15 festgelegt sind. Die Leiterstreifen 33 können teilweise in den Querstegen 22 angeordnet werden. An den Querstegen 21 sind Haltemittel 24 für große Kondensatorbauelemente 60 ausgebildet. Die Querstege 23 weisen Haltemittel 25 für Leistungstransistoren 50 in Form von rechtwinkligen Aussparungen auf.

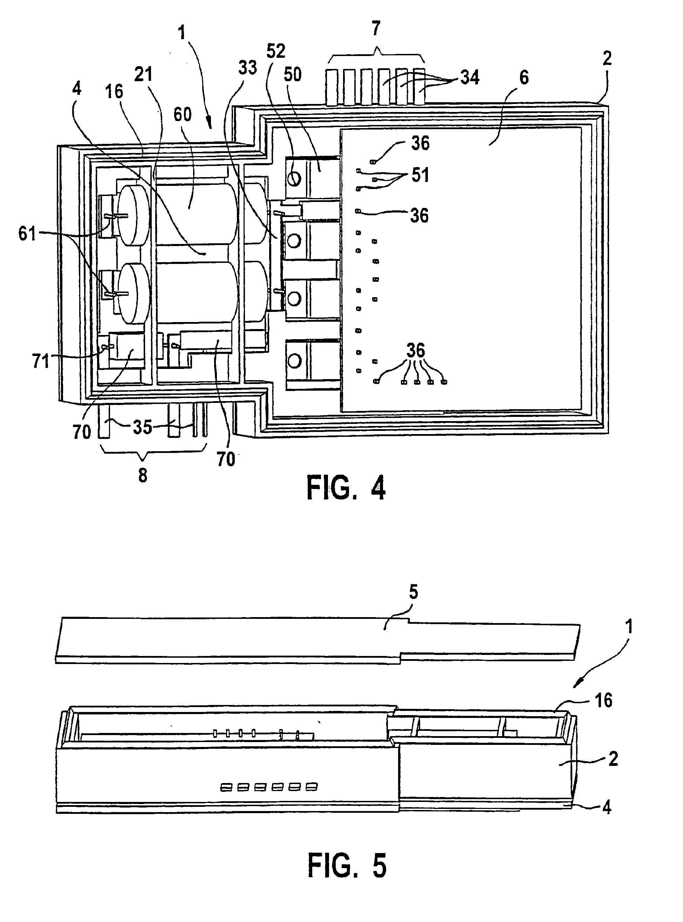

In Fig. 4 ist das fertig montierte Steuergerät bei abgenommenem Deckel dargestellt. Die Kondensatorbauelemente 60 und weitere elektrische Bauelemente 70 können von der offenen Unterseite 11 des Gehäuserahmens 2 in die Haltemitteln 24 der Querstege 21 eingelegt werden. Die Anschlüsse 61 der Kondensatorbauelemente 60 und die Anschlüsse 71 der weiteren Bauelemente 70 werden in die Öffnungen 37 der Leiterstreifen 33 eingesteckt und beispielsweise mit den Leiterstreifen verlötet. Anschließend wird eine metallische Bodenplatte 4, welche in Fig. 3 dargestellt ist, auf die Unterseite 11 des Gehäuserahmens aufgesetzt und mit diesem verklebt, verschraubt, über Rastmittel oder in sonstiger geeigneter Weise verbunden. Das metallische Bodenteil 4 weist Versenkungen 41 auf, welche in ihrer Kontur den Kondensatorbauelementen 60 angepaßt sind. Beim Aufsetzen des Bodenteils 4 werden die Kondensatorbauelemente 60 teilweise in den Versenkungen 41 angeordnet, so daß eine besonders flache Bauform möglich ist.

Wie in Fig. 4 weiterhin zu erkennen ist, ist eine mit elektronischen Schaltungsteilen versehene Leiterplatte 6 in den Gehäuserahmen 2 eingesetzt. Leistungstransistoren 50 sind mit ihren jeweils drei Anschlüssen 51, welche durch Kontaktöffnungen der Leiterplatte hindurchgeführt sind, mit der Leiterplatte 6 elektrisch verbunden. Dies kann vor dem Einsetzen der Leiterplatte 6 in den Gehäuserahmen erfolgen. Es ist auch möglich die Anschlüsse 51 der Leistungstransistoren 50 zumindest teilweise unmittelbar mit den zur Hochstromleitung vorgesehenen Leiterstreifen 33 des Stanzgitters 3 zu verbinden. Die Leistungstransistoren 50 weisen auf ihrer Unterseite eine Kühlplatte 52 auf, beispielsweise eine Kupferplatte. Die Anschlüsse 51 der Leistungstransistoren 50 sind zu der von der Kühlplatte 52 abgewandten Oberseite der Leistungstransistoren hin rechtwinklig abgebogen und in dieser Richtung in die Kontaktöffnungen der Leiterplatte eingesteckt. Vorteilhaft erstrecken sind die Anschlüsse 51 parallel zu den Kontaktabschnitten 36 der Leiterstreifen, so daß diese zusammen in einem Verfahrensschritt mit der Leiterplatte beispielsweise durch Tauchlötung verlötet werden können. Die von der Leiterplatte abgewandte Unterseite 52 der Leistungstransistoren 50 gelangt unmittelbar an einem Podest 42 des metallischen Bodenteils 4 zur Anlage. Es ist auch möglich die Leistungstransistoren 50 über einen wärmeleitenden Kleber oder ähnliches auf das metallische Bodenteil 4 aufzubringen. Die Querstege 22 des Gehäuserahmens dienen vorteilhaft auch zur Festlegung der Leiterplatte 6. Wie in Fig. 4 zu erkennen ist, wird durch den dargestellten Aufbau trotz der vorhandenen Wärmesenke 4 eine äußerst kompakte und flache Bauform ermöglicht, wobei die Leistungstransistoren 50 die erzeugte Wärme unmittelbar an das Bodenteil 4 ableiten. Nach dem Einsetzen der Leiterplatte 6 wird das Deckelteil 5 auf die umlaufende Dichtung 16 auf der Oberseite 10 des Steuergerätes aufgesetzt, wie in Fig. 5 dargestellt ist.

## Patentansprüche

1. Elektronisches Steuergerät mit einer in einem geschlossenen Gehäuse angeordneten, mit elektrischen und/oder elektronischen Bauelementen (50) versehenen Leiterplatte (6) und mit wenigstens einem an dem Gehäuse (1) angeordneten Stekkerteil (7,8), dessen in das Gehäuse teilweise eingebetteten Kontaktelemente (34,35) mit der Leiterplatte (6) elektrisch verbunden sind, **dadurch gekennzeichnet, daß** das Gehäuse (1) einen als Spritzgußteil hergestellten Gehäuserahmen (2) mit einer offenen Oberseite (10) und offenen Unterseite (11) umfaßt, in den durch wenigstens ein Stanzgitter (3) gebildete metallische Leiterstreifen (33) teilweise eingebettet sind, daß die Unterseite (11) des Gehäuserahmens (2) mit einem als Wärmesenke vorgesehenen metallischen Bodenteil (4) und die Oberseite (10) mit einem Deckelteil (5) verschlossen ist und daß zwischen dem Bodenteil (4) und der Leiterplatte (6) Leistungsbauelemente (50) vorgesehen sind, deren Anschlüsse (51) mit der Leiterplatte (6) und/oder den Leiterstreifen (33) kontaktiert sind und deren durch eine Kühlplatte (52) gebildete, von der Leiterplatte abgewandte Unterseite mit dem metallischen Bodenteil (4) wärmeleitend verbunden ist.

2. Elektronisches Steuergerät nach Anspruch 1, **dadurch gekennzeichnet, daß** der Gehäuserahmen (2) mit Querstegen (21, 22) versehen ist, an welchen Haltemittel (25) für die Leistungsbauelemente (50) und/oder Haltemittel (26) für weitere elektrische Bauelemente (60,70) ausgebildet sind.

3. Elektronisches Steuergerät nach Anspruch 1, **dadurch gekennzeichnet, daß** die Kontaktelemente (34,35) des wenigstens einen Steckerteils (7,8) durch die metallischen Leiterstreifen (33) ausgebildet sind.

4. Elektronisches Steuergerät nach Anspruch 1, **dadurch gekennzeichnet, daß** die Leiterplatte (6) zwischen den Leiterstreifen (33) und dem Deckelteil (5) angeordnet ist.

5. Elektronisches Steuergerät nach Anspruch 4, **dadurch gekennzeichnet, daß** senkrecht von den Leiterstreifen (33) zur Oberseite (10) des Gehäuserahmens (2) hin abgebogene Kontaktabschnitte (36) der Leiterstreifen durch Kontaktöffnungen der Leiterplatte (6) hindurchgeführt und mit der Leiterplatte elektrisch verbunden sind.

6. Elektronisches Steuergerät nach Anspruch 1, **dadurch gekennzeichnet, daß** die Oberseite (10) und/oder Unterseite (11) des Gehäuserahmens mit einer umlaufenden Dichtung (16) versehen ist.

7. Elektronisches Steuergerät nach Anspruch 1, **dadurch gekennzeichnet, daß** das metallische Bodenteil (4) mit wenigstens einer Versenkung (41) und/oder wenigstens einem Podest (42) zur Anlage der Leistungsbauelemente (50) und/oder der weiteren elektrischen Bauelemente (60,70) versehen ist.

8. Elektronisches Steuergerät nach einem der verstehenden Ansprüche, **dadurch gekennzeichnet, daß** das aus Gehäuserahmen (2), metallischem Bodenteil (4) und Deckelteil gebildete Gehäuse (1) ein hermetisch dicht verschlossenes Gehäuse ist.

## Claims

1. Electronic control unit comprising a printed circuit board (6), which is arranged in a closed housing and is provided with electrical and/or electronic components (50), and comprising at least one plug part (7, 8) which is arranged on the housing (1) and whose contact elements (34, 35) partly embedded into the housing are electrically connected to the printed circuit board (6), **characterized in that** the housing (1) comprises a housing frame (2) produced as an injection-moulded part and having an open top side (10) and open underside (11), into which metallic conductor strips (33) formed by at least one leadframe (3) are partly embedded, **in that** the underside (11) of the housing frame (2) is closed off with a metallic base part (4) provided as a heat sink and the top side (10) is closed off with a cover part (5), and **in that** there are provided between the base part (4) and the printed circuit board (6) power components (50) whose connections (51) are contact-connected to the printed circuit board (6) and/or the conductor strips (33) and whose underside that is formed by a cooling plate (52) and is remote from the printed circuit board is thermally conductively connected to the metallic base part (4).

2. Electronic control unit according to Claim 1,
**characterized in that** the housing frame (2) is provided with transverse webs (21, 22), at which holding means (25) for the power components (50) and/or holding means (26) for further electrical components (60, 70) are formed.

3. Electronic control unit according to Claim 1, **characterized in that** the contact elements (34, 35) of the at least one plug part (7, 8) are formed by the metallic conductor strips (33).

4. Electronic control unit according to Claim 1, **characterized in that** the printed circuit board (6) is arranged between the conductor strips (33) and the cover part (5).

5. Electronic control unit according to Claim 4, **characterized in that** contact sections (36) of the conductor strips that are bent away perpendicular from the conductor strips (33) towards the top side (10) of the housing frame (2) are led through contact openings in the printed circuit board (6) and are electrically connected to the printed circuit board.

6. Electronic control unit according to Claim 1, **characterized in that** the top side (10) and/or underside (11) of the housing frame are/is provided with a circumferential seal (16).

7. Electronic control unit according to Claim 1, **characterized in that** the metallic base part (4) is provided with at least one recess (41) and/or at least one pedestal (42) for bearing the power components (50) and/or the further electrical components (60, 70).

8. Electronic control unit according to any of the preceding claims, **characterized in that** the housing (1) formed from housing frame (2), metallic base part (4) and cover part is a hermetically tightly sealed housing.

## Revendications

1. Appareil de commande électronique comprenant un boîtier fermé recevant une plaque de circuit (6) munie de composants électriques et/ou électroniques (50) et au moins une pièce de connexion (7, 8) installée sur le boîtier (1) et dont les éléments de contact (34, 35) intégrés en partie dans le boîtier sont reliés électriquement à la plaque de circuit (6),
**caractérisé en ce que**
le boîtier (1) comporte un cadre de boîtier (2) fabriqué comme pièce injectée munie d'un côté supérieur ouvert (10) et d'un côté inférieur ouvert (11), dans lesquels sont intégrés au moins en partie des rubans conducteurs métalliques (33) formés par au moins une grille découpée à la matrice (3),
la face inférieure (11) du cadre (2) du boîtier est fermée par une pièce de fond (4) métallique prévue comme puits à chaleur et le côté supérieur (10) est fermé par une pièce de couvercle (5) et
entre la pièce de fond (4) et la plaque de circuit (6) il y a des composants de puissance (50) dont les branchements (51) sont en contact avec la plaque de circuit (6) et/ ou les rubans conducteurs (33) et dont la face inférieure formée par une plaque de refroidissement (52), à l'opposé de la plaque de circuit, est reliée en conduction thermique avec la pièce de fond métallique (4).

2. Appareil de commande électronique selon la revendication 1,
**caractérisé en ce que**
le cadre de boîtier (2) est muni de traverses (21, 22) sur lesquelles sont réalisés des moyens de fixation (25) pour les composants de puissance (50) et/ou les moyens de fixation (26) pour d'autres composants électriques (60, 70).

3. Appareil de commande électronique selon la revendication 1,
**caractérisé en ce que**
les éléments de contact (34, 35) d'au moins une partie de connecteur (7, 8) sont réalisés par des rubans conducteurs métalliques (33).

4. Appareil de commande électronique selon la revendication 1,
**caractérisé en ce que**
la plaque de circuit (6) est installée entre les rubans conducteurs (33) et la pièce formant le couvercle (5).

5. Appareil de commande électronique selon la revendication 4,
**caractérisé par**
des segments de contact (36) des rubans conducteurs recourbés perpendiculairement à partir des rubans conducteurs (33) vers le côté supérieur (10) du cadre de boîtier (2), et traversant des orifices de contact de la plaque de circuit (6) en étant reliés électriquement à la plaque de circuit.

6. Appareil de commande électronique selon la revendication 1,
**caractérisé en ce que**
le côté supérieur (10) et/ ou le côté inférieur (11) du cadre de boîtier est muni d'un joint périphérique (16).

7. Appareil de commande électronique selon la revendication 1,
**caractérisé en ce que**
la pièce de fond métallique (4) est munie d'au moins une partie en creux (41) et/ou d'au moins une partie en relief (42) pour l'appui des composants de puissance (50) et/ou des autres composants électriques (60, 70).

8. Appareil de commande électronique selon l'une des revendications précédentes,
**caractérisé en ce que**
le boîtier (1) comprenant le cadre de boîtier (2), la pièce de fond métallique (4) et la pièce de couvercle est un boîtier fermé de manière hermétique.
